# EUROPEAN PATENT APPLICATION

(11) **EP 3 736 793 A1**
(43) Date of publication of application: **11.11.2020**
(21) Application number: 20155574.5
(22) Date of filing: 05.02.2020
(51) Int. Cl.: G09F 9/302

(54) **LIFTING LOCK AND LED DISPLAY SCREEN WITH THE LIFTING LOCK**

(30) Priority: 05.05.2019 CN 201920639099 U
(71) Applicant: Unilumin Group Co. Ltd., Shenzhen, Guangdong 518103 (CN)
(72) Inventor: Dai, Xiaotian, Shenzhen, Guangdong, 518103 (CN); Li, Jinxing, Shenzhen, Guangdong, 518103 (CN)
(74) Representative: Osterhoff, Utz

(57) **Abstract**

Disclosed are a lifting lock and a LED display screen (100) having the lifting lock (200). The lifting lock includes a first lifting mechanism (210) and a second lifting mechanism (220). The first lifting mechanism includes a first base and a lock head, and a plug hole and a clamping groove are arranged on the lock head. The second lifting mechanism includes a second base, a plug structure, a safety structure arranged on the second base. The second base includes a lock hole extending along a longitudinal direction, and the lock head is movably inserted in the lock hole. The safety structure includes an elastic bolt movable along the horizontal direction and configured to cooperate with the clamping groove to lock the lock head. The plug structure includes a plug movable along a horizontal direction and configured to match with the plug hole to lock the lock head.

## Description

### TECHNICAL FIELD

The present disclosure relates to the technical field of LED display screen assembly, in particular to a lifting lock and a LED display screen with the lifting lock.

### BACKGROUND

With the rapid development of LED display industry, there are more and more new products on the market, such as, fixed screen, stage screen, rental screen, TV screen, and so on. The rental screen, often used in activities for commercial publicity and stage performance, is much more popular due to its advantages, such as quick assembly and disassembly, and quick maintenance. In detail, the rental screen can be hoisted or fixed on somewhere, or installed on the ground. In this condition, the customers' experience of installing LED panels from up-down direction and left-right direction is particularly important. The less time and labor required, the better the operating experience, and the cost is reduced accordingly to suit the market.

### SUMMARY

The main purpose of the present disclosure is to provide a lifting lock and an LED display screen with the lifting lock, which aims to enable one person quickly connect LED panels together by hands, to save the time and labor required and ensure the security and reliability of the connection of the LED panels.

In order to achieve the above objective, the present disclosure provides a lifting lock for locking a first LED panel with a second LED panel adjacent to the first LED panel. The lifting lock includes a first lifting mechanism fastened to the first LED panel and a second lifting mechanism fastened to the second adjacent LED panel. The first lifting mechanism includes a first base and a lock head arranged on the first base, and a plug hole and a clamping groove are arranged on the lock head. And the second lifting mechanism includes a second base, a plug structure and a safety structure arranged on the second base. And the second base includes a lock hole extending along a longitudinal direction, and the lock head is movably inserted in the lock hole. The plug structure includes a plug movable along a horizontal direction, and the plug is matched with the plug hole to lock the lock head. And the safety structure includes an elastic bolt movable along the horizontal direction, and the elastic bolt is matched with the clamping groove to clamp the lock head.

Optionally, the lifting lock includes a screw structure, the lock head being fastened to the first base through the screw structure; and a screw structure group, the first base being fastened to the first LED panel through the screw structure group.

Optionally, the second base further includes an accommodating hole extending along the horizontal direction and configured to receive the plug, and connect with a side wall of the lock hole.

Optionally, the lifting lock further includes: a set screw arranged on a side wall of an end of the accommodating hole adjacent to the lock hole, the set screw being matched with a limit hole groove at the plug to limit and lock the plug.

Optionally, the lifting lock further includes: two opposite bead screws, arranged on a side wall of an end of the accommodating hole away from the lock hole, and the bead screws are matched with a protection hole groove at the plug to prevent the plug from sliding.

Optionally, the elastic bolt includes a return spring and a bolt body. The bolt body includes a first bottom plate and a first side plate. The first bottom plate includes a receiving groove for receiving the return spring, and a first side plate cooperated with the first bottom plate to form an included angle. And the safety structure further includes a knob movably abutted against the first side plate.

In addition, in order to achieve the above objective, the present disclosure also provides a LED display screen, including a plurality of LED panels and a plurality of lifting locks as mentioned above. The LED panels are connected together by the lifting locks.

Optionally, one side of the LED panel includes a mounting groove for mounting the first base or the second base; and the first base includes a second bottom plate, a third bottom plate and a second side plate, an upper side wall of the mounting groove, the second bottom plate, the second side plate, a lower side wall of the mounting groove and the third bottom plate are sequentially fastened together through a screw structure group.

Optionally, The LED display screen further includes a nut gasket, a nut, and a screw. The lock head is fastened to the upper side wall of the mounting groove and the second bottom plate through a sequential cooperation of the nut gasket and the nut with an external thread on the lock head; and the lock head is fastened to the lower side wall of the mounting groove and the third bottom plate through a sequential cooperation of the screw and an internal thread on the lock head.

In the installation process of the LED display screen, the first lifting mechanism of the lifting lock is fastened to a first LED panel and the second lifting mechanism is fastened to a second LED panel adjacent to the first LED panel. Then the lock head of the first lifting mechanism is inserted into the lock hole of the second lifting mechanism. When the lock head is completely pushed into the lock hole, the elastic bolt of the safety structure is squeezed out. So that the elastic bolt is matched and fit with the clamping groove at the lock head under the reset effect of the the elastic bolt, to clamp the lock head and further prevent the LED panels from falling off. At this time, an installation worker can manually operate the plug of the plug structure to transversely insert the plug into the bolt hole at the lock head, to lock the lock head. By doing so two adjacent LED panels are connected together. Such one person can connect LED panels by hands quickly, to save the time and labor required, and ensure the security and reliability of the connection of the LED panels.

### BRIEF DESCRIPTION OF THE DRAWINGS

The technical solutions of the embodiments of the present disclosure will be clearly and completely described in the following with reference to the accompanying drawings. It is obvious that the embodiments to be described are only a part rather than all of the embodiments of the present disclosure. All other embodiments obtained by persons skilled in the art based on the embodiments of the present invention without creative efforts shall fall within the protection scope of the present invention.
FIG. 1 is a partial structural diagram of a LED display screen according to an embodiment of the present disclosure.
FIG. 2 is a structural diagram of the lifting lock of the LED display screen according to FIG.1.
FIG. 3 is an exploded view of the lifting lock according to FIG. 2.

### DETAILED DESCRIPTION OF THE EMBODIMENTS

As following, the technical solution in the embodiments of the present disclosure will be described clearly and completely with reference to the drawings in the embodiment of the present disclosure. Obviously, the described embodiment is only a part of the embodiment of the present disclosure, not all of the embodiments. Based on the embodiments in the present disclosure, all other embodiments perceived by those ordinary skills in the art without creative effort should be fallen within the protection scope of the present disclosure.

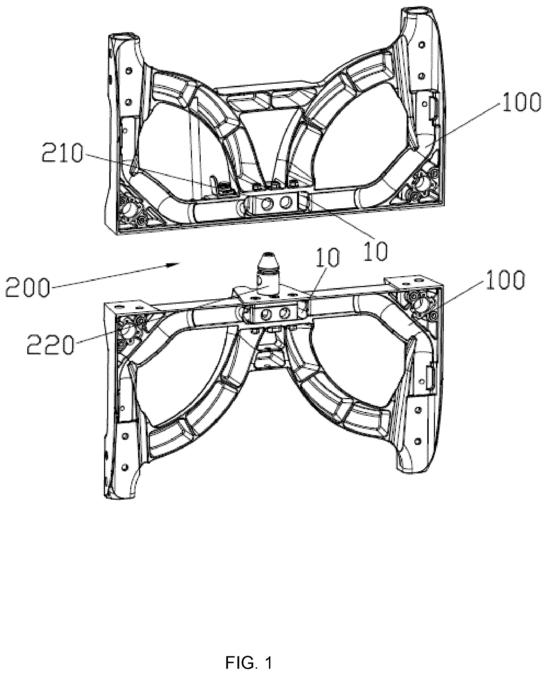

As shown in FIG. 1, the embodiment of the present disclosure provides a LED display screen, which includes a plurality of LED panels 100 and a plurality of lifting locks 200. And the lifting lock 200 include a first lifting mechanism 210 and a second Lifting structure 200. The first lifting mechanism 210 is fastened to a first LED panel 100, and the second lifting mechanism 220 is fastened to a second LED panel 220 adjacent to the first LED panel 100. So that the LED panels adjacent to each other along an up-down direction are fastened and connected together through the lifting locks 200.

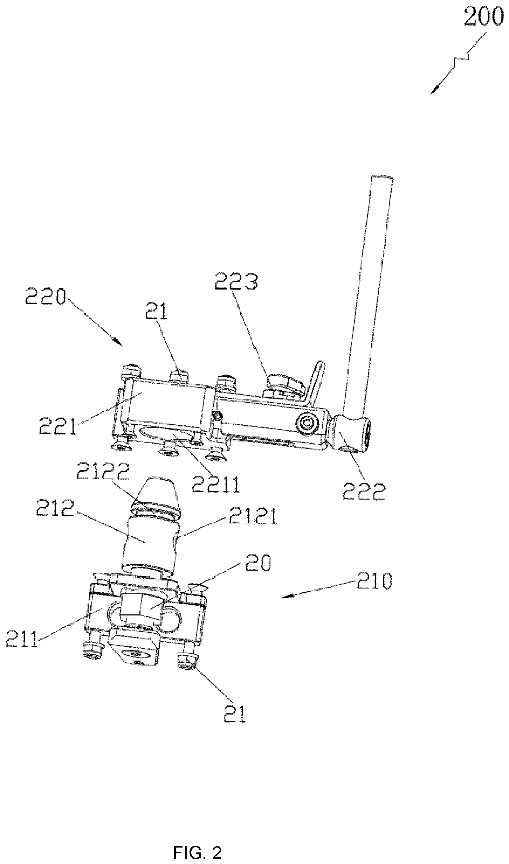

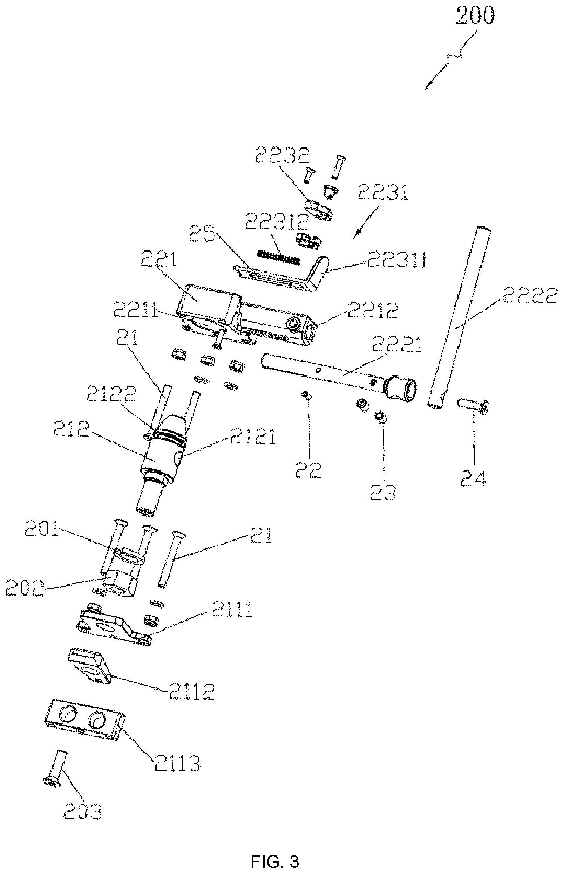

In the present embodiment, as shown in FIG. 2 and FIG. 3, the first lifting mechanism 210 includes a first base 221 and a lock head 212 arranged on the first base 221. A plug hole 2121 and a clamping groove 2122 are arranged at the lock head 212. And the second lifting mechanism 220 includes a second base 221, a plug structure 222 and a safety structure 223 arranged on the second base 221. And the second base 221 includes a lock hole 2211 extending along a longitudinal direction, and the lock head 212 is movably inserted in the lock hole 2211. The safety structure 223 includes an elastic bolt 2231 movable along the horizontal direction, and the elastic bolt is cooperated with the clamping groove 2122 to clamp the lock head. The plug structure 222 includes a plug 2221 movable along a horizontal direction, and the plug 2221 is matched with the plug hole 2121 to lock the lock head 212.

Specifically, as shown in FIG. 1, FIG.2 and FIG.3, the lock head 212 is fastened to the first base 211 through a screw structure 20. The first base 211 is fastened to one LED panel 100 through a screw structure group 21. And the second base 221 is fastened to another one LED panel 100 through the screw structure group 21. The screw structure group 21 includes three screws arranged side by side to form a screw structure group to strengthen and fasten the connection between the first base 211 and the LED panel 100, or between the second base 221 and the LED panel 100. One side of the LED panel 100 includes a mounting groove 10 for mounting the first base 211 or the second base 221. The first base 211 includes a second bottom plate 2111, a third bottom plate 2112 and a second side plate 2113. And an upper side wall of the mounting groove 10, the second bottom plate 2111, the second side plate 2113, a lower side wall of the mounting groove 10 and the third bottom plate 2112 are sequentially fastened together through the screw structure group 21. In the present embodiment, the second bottom plate 2111 specifically adopts a T-shaped plate structure, and the third bottom plate 2112 and the second side plate 2113 both adopt a strip-shaped plate structure. And the lock head 212 is fastened with the upper side wall of the mounting groove 10 and the second bottom plate 2111 through a sequential cooperation of the nut gasket 201, the nut 202, and an external thread on the lock head 212. And the lock head 212 is fastened with the lower side wall of the mounting groove 10 and the third bottom plate 2112 through a sequential cooperation of the screw 203 and an internal thread on the lock head 212. By arranging the second bottom plate 2111 on the bottom side of the upper side wall of the mounting groove 10, sandwiching the second side plate 2113 between the upper side wall of the mounting groove 10 and the lower side wall of the mounting groove 10, and arranging the third bottom plate 2113 on the bottom side of the lower side wall of the mounting groove 10, the lock head 212 can be fixed and the stressed area is increased.

As shown in FIG. 2 and FIG. 3, the second base 221 further includes an accommodating hole 2212 extending along the horizontal direction and configured to receive the plug 2221 and connect with a side wall of the lock hole 2211. The lifting lock further includes a set screw 22 arranged on a side wall of an end of the accommodating hole 2212 adjacent to the lock hole 2211, and the set screw 22 is matched with a limit hole groove at the plug 2221 to limit and lock the plug 2221. The set screw 22 is configured to control the rotation angle of the plug 2221 to ensure that the plug 2221 is absolutely locked with the lock head 212, and to limit the plug 2221 from sliding when the bolt is pulled out. Two opposite bead screws 23 are arranged on a side wall of an end of the accommodating hole 2212 away from the lock hole 2211, the bead screws are matched with a protection hole groove at the plug 2221 to prevent the plug 2221 from sliding. The plug structure 222 further includes a handle 2222 fixed at one end of the plug 2221 away from the plug hole 2121 through a screw structure 24. When the plug 2221 is unlocked, the bead screw 23 is configured to prevent the plug 2221 and the handle 2222 from colliding each other due to a high freedom degree during transportation. The elastic bolt 2231 includes a bolt body 22311 and a return spring 22312. And the bolt body 22311 includes a first bottom plate including a receiving groove 25 for receiving the return spring 22312 and a first side plate cooperated with the first bottom plate to form an included angle. And the safety structure 223 further includes a knob movably 2232 abutted against the first side plate. When it needs to splice the panels, the safety knob 2232 is in an open state, and the bolt body 22311 is configured to lock the lock head 212 under the elastic force of the return spring 22312. When it needs to disassemble the panels, the knob 2232 is rotated to resist the first side plate, so that the bolt body 22311 is pulled out from the clamping groove 2122.

In the installation process of the LED display screen, the first lifting mechanism of the lifting lock is fastened to a first LED panel and the second lifting mechanism is fastened to a second LED panel adjacent to the first LED panel. Then the lock head of the first lifting mechanism is inserted into the lock hole of the second lifting mechanism. When the lock head is completely pushed into the lock hole, the elastic bolt of the safety structure is squeezed out. So that the elastic bolt is matched and fit with the clamping groove at the lock head under the reset effect of the the elastic bolt, to clamp the lock head and further prevent the LED panels from falling off. At this time, an installation worker can manually operate the plug of the plug structure to transversely insert the plug into the bolt hole at the lock head, to lock the lock head. By doing so two adjacent LED panels are connected together. Such one person can connect LED panels by hands quickly, to save the time and labor required, and ensure the security and reliability of the connection of the LED panels.

The foregoing description merely depicts some preferred embodiments of the present application and therefore is not intended to limit the scope of the application. An equivalent structural or flow changes made by using the content of the specification and drawings of the present application, or any direct or indirect applications of the disclosure on any other related fields shall all fall in the scope of the application.

## Claims

1. A lifting lock, for locking a first LED panel with a second LED panel, comprising:
a first lifting mechanism fastened to the first LED panel, and comprising:
a first base and
a lock head arranged on the first base, a plug hole and a clamping groove being arranged in the lock head; and
a second lifting mechanism fastened to the second adjacent LED panel, and comprising:
a second base comprising a lock hole extending along a longitudinal direction, the lock head being movably inserted in the lock hole;
a plug structure arranged on the second base, and comprising a plug movable along a horizontal direction, and the plug being matched with the plug hole to lock the lock head; and
a safety structure arranged on the second base, and comprising an elastic bolt movable along the horizontal direction, and the elastic bolt being matched with the clamping groove to clamp the lock head.

2. The lifting lock of claim 1, further comprising:
a screw structure, the lock head being fastened to the first base through the screw structure; and
a screw structure group, the first base being fastened to the first LED panel through the screw structure group.

3. The lifting lock of claim 1 or 2, wherein the second base further comprises:
an accommodating hole extended along the horizontal direction and configured to:
receive the plug, and
connect with a side wall of the lock hole.

4. The lifting lock of any one of claims 1 to 3, further comprising:
a set screw arranged on a side wall of an end of the accommodating hole adjacent to the lock hole, the set screw being matched with a limit hole groove at the plug to limit and lock the plug.

5. The lifting lock of any one of claims 1 to 3, further comprising:
two opposite bead screws, arranged on a side wall of an end of the accommodating hole away from the lock hole, the bead screws being matched with a protection hole groove at the plug to prevent the plug from sliding.

6. The lifting lock of claim 1, the plug structure further comprises: a handle fixed at one end of the plug away from the plug hole through a screw structure.

7. The lifting lock of claim 1, wherein:
the elastic bolt comprises:
a return spring; and
a bolt body comprising:
a first bottom plate comprising a receiving groove for receiving the return spring, and
a first side plate cooperated with the first bottom plate to form an included angle; and
the safety structure further comprises a knob movably abutted against the first side plate.

8. A LED display screen, comprising a plurality of LED panels and a plurality of lifting locks, each lifting lock comprising:
a first lifting mechanism fastened to a first LED panel, and comprising:
a first base and
a lock head arranged on the first base, a plug hole and a clamping groove being arranged in the lock head; and
a second lifting mechanism fastened to a second adjacent LED panel, and comprising:
a second base comprising a lock hole extending along a longitudinal direction, the lock head being movably inserted in the lock hole;
a plug structure arranged on the second base, and comprising a plug movable along a horizontal direction, and the plug being matched with the plug hole to lock the lock head; and
a safety structure arranged on the second base, and comprising an elastic bolt movable along the horizontal direction, and the elastic bolt being matched with the clamping groove to clamp the lock head.

9. The LED display screen of claim 8, wherein:
one side of the LED panel comprises a mounting groove for mounting the first base or the second base; and
the first base comprises a second bottom plate, a third bottom plate and a second side plate, an upper side wall of the mounting groove, the second bottom plate, the second side plate, a lower side wall of the mounting groove and the third bottom plate are sequentially fastened together through a screw structure group.

10. The LED display screen of claim 8 or 9, further comprising a nut gasket, a nut, and a screw, wherein:
the lock head is fastened to the upper side wall of the mounting groove and the second bottom plate through a sequential cooperation of the nut gasket and the nut with an external thread on the lock head; and
the lock head is fastened to the lower side wall of the mounting groove and the third bottom plate through a sequential cooperation of the screw and an internal thread on the lock head.

11. The LED display screen of claim 8 , further comprising:
a screw structure, the lock head being fastened to the first base through the screw structure; and
a screw structure group, the first base being fastened to the first LED panel through the screw structure group.

12. The LED display screen of any one of claims 8 to 11, wherein the second base further comprises:
an accommodating hole extended along the horizontal direction and configured to:
receive the plug, and
connect with a side wall of the lock hole.

13. The LED display screen of any one of claims 8 to 12, further comprising:
a set screw arranged on a side wall of an end of the accommodating hole adjacent to the lock hole, the set screw being matched with a limit hole groove at the plug to limit and lock the plug.

14. The LED display screen of claim 12, further comprising:
two opposite bead screws, arranged on a side wall of an end of the accommodating hole away from the lock hole, the bead screws being matched with a protection hole groove at the plug to prevent the plug from sliding.

15. The LED display screen of claim 8, wherein:
the elastic bolt comprises:
a return spring; and
a bolt body comprising:
a first bottom plate comprising a receiving groove for receiving the return spring, and
a first side plate cooperated with the first bottom plate to form an included angle; and
the safety structure further comprises a knob movably abutted against the first side plate.
